# EUROPÄISCHE PATENTSCHRIFT

(11) **EP 0 901 166 B1**
(45) Veröffentlichungstag und Bekanntmachung des Hinweises auf die Patenterteilung: **21.11.2001**
(21) Anmeldenummer: 98810693.6
(22) Anmeldetag: 20.07.1998
(51) Int. Cl.: H01L 25/07, H01L 23/367

(54) **Leistungshalbleitermodul mit in Submodulen integrierten Kühlern**
Power semiconductor device module with submodules having integrated coolers
Module semi-conducteur à haute puissance avec une pluralité de sous-modules comprenant des éléments de refroidissement intégrés

(30) Priorität: 16.08.1997 DE 19735531
(43) Veröffentlichungstag der Anmeldung: 10.03.1999
(73) Patentinhaber: ABB RESEARCH LTD., 8050 Zürich (CH)
(72) Erfinder: Etter, Peter, 5422 Oberehrendingen (CH); Stuck, Alexander, Dr., 5430 Wettingen (CH); Zehringer, Raymond, Dr., 4132 Muttenz (CH)
(74) Vertreter: ABB Patent Attorneys

(56) Entgegenhaltungen:
- EP-A- 0 597 144
- EP-A- 0 676 800
- EP-A- 0 776 042
- DE-A- 4 338 706
- US-A- 5 227 338

## Beschreibung

### TECHNISCHES GEBIET

Die vorliegende Erfindung bezieht sich auf das Gebiet der Leistungselektronik. Sie geht aus von einem Leistungshalbleitermodul mit einer Mehrzahl von Submodulen nach dem Oberbegriff des Anspruchs 1.

### STAND DER TECHNIK

Leistungshalbleiter für Industrie-, Traktions- und andere Anwendungen sind häufig modular aus mehreren Leistungshalbleiterbauelementen, wie z. B. Thyristoren, GTOs (gate turn - off thyristors), MCTs (MOS - controlled thyristors), Leistungsdioden, IGBTs (insulated gate bipolar transistors) oder MOSFETS (MOS - controlled field effect transistors), aufgebaut. Insbesondere MOS - gesteuerte Halbleiterchips können nur mit relativ kleinen aktiv steuerbaren Flächen bzw. Schaltleistungen hergestellt werden. Deshalb werden z. B. für ein 1200 A - Modul typischerweise 20 IGBTs zu einem Leistungshalbleitermodul parallelgeschaltet. Beispiele für solche Module sind aus der EP-A1-0 597 144 oder aus einem Artikel von T. Stockmeier et al., "Reliable 1200 Amp 2500 V IGBT Modules for Traction Applications", IEEE IGBT Propulsion Drives Colloquium, London, April 1995, bekannt.

Die Abführung der Verlustwärme von den Leistungshalbleitern stellt erhebliche Anforderungen an die thermische Lastwechselfestigkeit und an das Kühlsystem eines Leistungshalbleitermoduls. Vor allem in Hochleistungsmodulen für Traktionsantriebe stellen die thermischen Probleme eine wesentliche Begrenzung der Langzeit - Zuverlässigkeit dar. Beim heutigen Stand der Technik ist einer der dominierenden Ausfallmechanismen die Ermüdung und Ablösung der Lotschicht zwischen den Halbleiterchip - Substraten und der wärmeabführenden Grundplatte oder dem Kühler. Dadurch kann der Chip überhitzt, Bondierungsdrähte abgelöst und schliesslich das gesamte Leistungshalbleitermodul zerstört werden. Die Lotermüdung und -ablösung wird nach einer Anzahl von Lastwechseln beobachtet, die ausser von den vorgegebenen Temperaturverhältnissen stark von der Kühlereffizienz abhängt. Es ist deshalb ein wichtiges Anliegen, den Aufbau, die Geometrie und die verwendeten Materialien des Kühlers zu optimieren.

Aus DE-A-4 338 706 and EP-A-676 800 sind Direktiverbindungsverfahren bekannt.

Schliesslich ist aus der DE 196 45 636 ein integrierter Aufbau eines Leistungsmoduls bekannt, bei dem die Leistungshalbleiter, die Ansteuerelektronik, die Stromschienen und ein Kühlkörper in einem gemeinsamen Gehäusekörper untergebracht sind. Dieses Leistungsmodul besitzt keinerlei Modularität. Vielmehr sind die Leistungshalbleiter grossflächig zwischen dem Monoblock - Substrat und - Kühler und der Ansteuerelektronik eingebettet und bilden einen quasi monolithischen Aufbau.

### DARSTELLUNG DER ERFINDUNG

Aufgabe der vorliegenden Erfindung ist es, ein Leistungshalbleitermodul mit mehreren Submodulen und einem verbesserten Kühleraufbau anzugeben, welches sich durch eine sehr hohe thermischen Belastbarkeit, grosse Langzeit - Zuverlässigkeit und verbesserte Modularität auszeichnet. Diese Aufgabe wird erfindungsgemäss durch die Merkmale des Anspruchs 1 gelöst.

Kern der Erfindung ist es nämlich, Leistungshalbleitermodule aus Submodulen mit integrierten Kühlern aufzubauen. Dabei weist ein Submodul genau ein Substrat auf, auf dessen Oberseite mindestens ein Halbleiterchip stoffschlüssig befestigt ist und mit dessen Unterseite ein Kühler vergossen ist.

Ein erstes Ausführungsbeispiel zeigt ein Leistungshalbleitermodul mit Submodulen und angegossenen Kühlern, die einen Kühlkörper in Form einer AlSiC-Platte und Kühlstrukturen in Form von Noppen oder Rippen aus AlSiC oder Aluminium aufweisen.

Ein zweites Ausführungsbeispiel stellt ein Leistungshalbleitermodul dar, bei dem die Kühlstrukturen in Form vorzugsweise kleiner Noppen unmittelbar auf die Substratunterseiten der Submodule aufgegossen sind.

Andere Ausführungsbeispiele betreffen u. a. die Verwendung eines Kunststoffgehäuses, an dessen Oberseite die Submodule gehaltert sind und in dessen Innenraum die Kühlelemente mit Wasser o. ä. gekühlt werden, sowie die Integration einer Steuerelektronik und/oder von Stromschienen im Leistungsmodul.

Zusätzliche Ausführungsformen ergeben sich aus den abhängigen Ansprüchen.

Ein Vorteil des erfindungsgemässen Leistungshalbleitermoduls besteht in seiner erhöhten Zuverlässigkeit und Lebensdauer vor allem aufgrund der deutlich verbesserten thermischen Lastwechselfestigkeit der Grenzflächen zwischen den Substraten und Kühlern.

Ein weiterer Vorteil des erfindungsgemässen Leistungshalbleitermoduls ist durch die Modularität des Kühleraufbaus gegeben. Dadurch sind defekte Submodule leicht austauschbar und das Kühlgehäuse einfach an eine je nach Schaltleistung gewünschte Anzahl Submodule adaptierbar.

Ein anderer Vorteil ist die kompakte Bauweise, die bei Leistungsmodulen mit integrierter Steuerelektronik und integrierten Stromschienenanschlüssen erzielbar ist.

Ferner ist ein Vorteil der Erfindung auch darin zu erkennen, dass Submodule mit integrierten Kühlern als Standardteile herstellbar und testbar sind, wodurch Materialverluste und Kosten reduziert werden können.

### KURZE BESCHREIBUNG DER ZEICHNUNG

Die Erfindung wird nachstehend anhand von Ausführungsbeispielen erläutert.

Es zeigen:
- Fig. 1: einen Schnitt durch ein Leistungshalbleitermodul mit einer ersten erfindungsgemässen Bauform integrierter Kühler für Submodule;
- Fig. 2: einen Schnitt durch ein Leistungshalbleitermodul mit einer zweiten erfindungsgemässen Bauform integrierter Kühler für Submodule;
- Fig. 3: eine Aufsicht auf ein Leistungshalbleitermodul gemäss Fig. 1 oder Fig. 2 mit 8 Submodulen.
- Fig. 4: einen Schnitt durch ein Leistungshalbleitermodul mit integrierter Steuerelektronik.
- Fig. 5: einen Schnitt durch eine spiegelsymmetrische Anordnung zweier Leistungshalbleitermodule nach Fig. 4.
- Fig. 6: ein vereinfachter Schnitt durch ein Leistungshalbleitermodulgehäuse mit integrierten Stromschienen.

In den Figuren sind gleiche Teile mit gleichen Bezugszeichen versehen.

### WEGE ZUR AUSFÜHRUNG DER ERFINDUNG

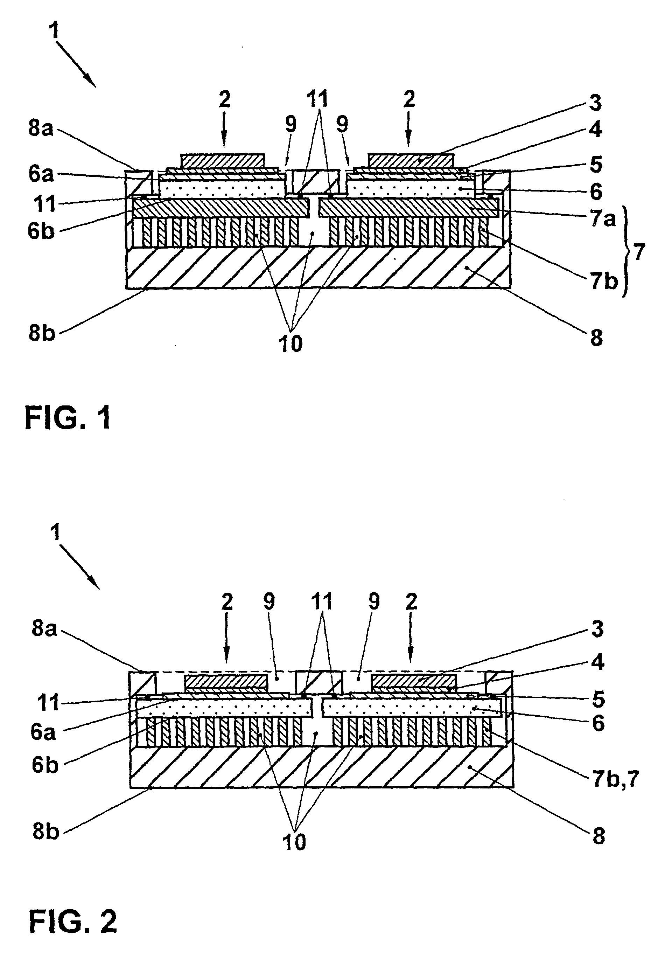

Fig. 1 zeigt eine bevorzugte Ausführungsform eines Leistungshalbleitermoduls 1, wie es Gegenstand der Erfindung ist. Ein Submodul 2 umfasst mindestens einen Halbleiterchip 3, der über eine Lotschicht 4 und eine Metallisierung 5 aus Kupfer oder Aluminium mit einer Oberseite 6a eines AlN - Substrates 6 verbunden ist. Das Substrat 6 umfasst einen mit seiner Unterseite 6b vergossenen Kühler 7, der einen Kühlkörper 7a in Form einer AlSiC - Platte und Kühlstrukturen 7b in Form von Noppen oder Rippen aus AlSiC oder Aluminium aufweist. Mehrere Submodule 2 sind zu einem Leistungshalbleitermodul 1 zusammengefasst. Dazu werden sie in Aussparungen 9 an einer Oberseite 8a eines Kunststoffgehäuses 8 angeordnet und ihre Kühler 7 zur Gehäuseunterseite 8b hin orientiert. Das Kunststoffgehäuse 8 umschliesst die Kühler 7 und das Kühlmedium 10, das über nicht dargestellte Öffnungen zu- und abgeführt wird. An der Gehäuseoberseite 8a sind im Randbereich der Submodule 2 Abdichtungen 11 in Form von O - Ringen, einer dicken Leimverbindung oder ähnlichem vorgesehen. Vorteilhafterweise befinden sich die Abdichtungen 11 zwischen der Gehäuseoberseite 8a und den Kühlkörpern 7a.

Ein solcher Kühleraufbau zeichnet sich durch eine hervorragende thermische Belastbarkeit aus. Thermomechanische Spannungen sind durch die Materialwahl der Submodule 2 weitgehend reduziert, da die Ausdehnungskoeffizienten des Halbleitermaterials 3, der AlN - Keramik und des AlSiC - Kühlers einander sehr gut angepasst sind. Bestehen die Kühlstrukturen aus Aluminium, kann der grosse Sprung im Ausdehnungskoeffizienten dadurch aufgefangen werden, dass Noppen oder Rippen 7b mit möglichst kleinen Kontaktflächen zum Kühlkörper 7a gewählt werden. Prinzipiell ist es auch möglich, den Kühler 7 mit einer von oben nach unten zunehmenden Aluminiumkonzentration und daher wachsendem Ausdehnungskoeffizienten zu giessen, so dass der Kühlkörper 7a mit grossflächigen Kühlstrukturen 7b sogar aus reinem Aluminium ausgestattet sein kann. Schliesslich wird eine grosse Differenz im Ausdehnungskoeffizienten zwischen dem Submodul 2 bzw. Kühler 7 und dem Kunststoffgehäuse durch die flexible oder elastische Abdichtung 11 aufgefangen.

Desweiteren ist es von Vorteil, dass durch den erfindungsgemässen Verguss des Kühlers unmittelbar mit dem Substrat 6 eine Lotschicht eliminiert wird. Der Verguss bewirkt eine mechanisch äusserst stabile und bestens temperatur- und lastwechselfeste Verbindung zwischen dem Substrat 6 und dem Kühler 7, wodurch die bisherigen Probleme mit Ermüdung und Ablösung an dieser kritischen Grenzfläche gelöst sind. Deshalb sind im Betrieb die Gefahren durch Kurzschlüsse, Explosionen usw. aufgrund thermomechanisch überstrapazierter Lötverbindungen weitgehend zurückgedrängt. Darüberhinaus entfällt der Beitrag der Lotschicht zum Wärmewiderstand zwischen dem Halbleiterchip 3 und dem Kühlwasser 10, wodurch eine Reduktion des Wärmewiderstands um typischerweise 1 K / kW bzw. 5% - 7% erzielt wird.

In Fig. 2 ist eine Variante eines erfindungsgemässen Leistungshalbleitermoduls 1 zu sehen. Im Unterschied zu Fig. 1 sind Kühlstrukturen 7b ohne einen Kühlkörper 7a vorgesehen. Die Kühlstrukturen 7a weisen eine Vielzahl von Noppen, Rippen, o. ä. auf, die direkt mit dem Substrat 6 vergossen sind und vorzugsweise aus AlSiC oder Aluminium bestehen. Selbst im Falle von Aluminium mit einem grossen Ausdehnungskoeffizienten treten z. B. bei Noppen 7a mit kleinen Durchmessern im mm - Bereich nur geringe thermomechanische Spannungen an der Grenzfläche zwischen dem Substrat 6 und den Noppen 7a auf. Die Abdichtungen 11 bestehen wie zuvor aus O - Ringen, dicken Leimverbindungen oder ähnlichem, sind aber nun zwischen der Gehäuseoberseite 8a und dem grösser gewählten Keramiksubstrat 6 angeordnet.

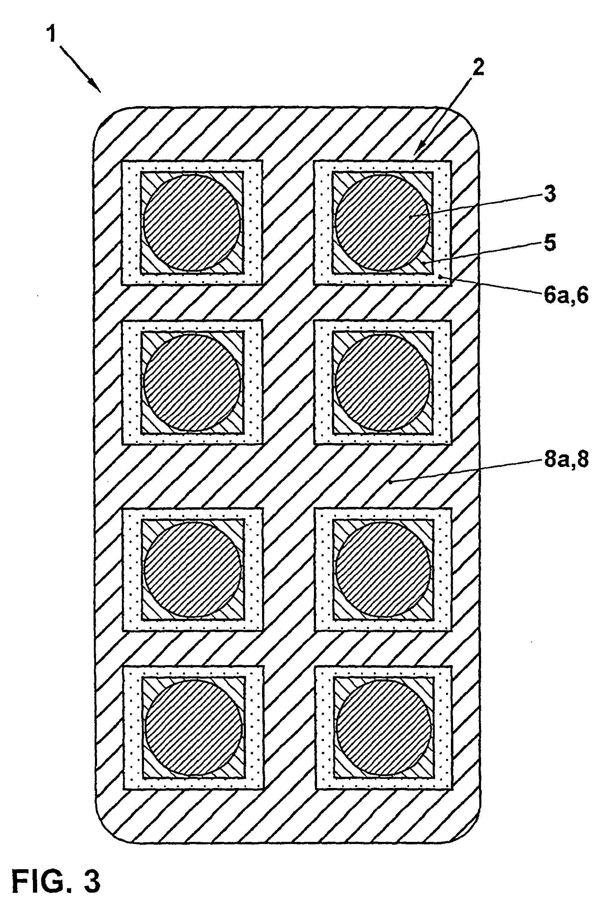

In Fig. 3 ist eine Aufsicht auf ein Leistungshalbleitermodul 1 gemäss Fig. 1 oder Fig. 2 mit 8 Submodulen 2 dargestellt. Die Halbleiterchips 3 sind durch nicht dargestellte Leiterbahnen, Anschlüsse, Terminals, Bondverbindungen usw. kontaktiert. Die Keramiksubstrate 6 sind wie zuvor dargelegt in Aussparungen 9 der Gehäuseoberseite oder einer Platte 8a eingelassen und bilden dadurch ein robustes, konsequent modular aufgebautes und flexibles Leistungshalbleitermodul 1 mit integrierter Kühlung. Insbesondere können Submodule 2 sehr einfach einzeln ausgetauscht werden, da sie nicht wie bisher üblich mit einem gemeinsamen Kühler verbunden sind und die Abdichtungen 11 auf einfache Weise lösbar und neu montierbar bzw. klebbar sind. Ferner kann die Gehäusegrösse, d. h. eine Anzahl von Aussparungen 9 bzw. Submodulen 2, sehr leicht nach Massgabe einer geforderten Schaltleistung des Leistungshalbleitermoduls 1 angepasst werden.

Die Erfindung umfasst auch weitere Ausführungsformen der Submodule 2 und Leistungshalbleitermodule 1, von denen einige nachfolgend näher erläutert werden.

Die Bestückung eines Submoduls 2 umfasst mindestens ein Leistungshalbleiterbauelement, wie z. B. Thyristor, GTO, MCT, Leistungsdiode, IGBT oder MOSFET. Ein Submodul 2 kann aber auch andere Beschaltungskomponenten beinhalten. Jedoch soll ein Submodul 2 nur wenige Elemente enthalten, um den Vorteil der Modularität und Flexibilität zu wahren. Besonders wünschenswert ist eine minimale Bestückung, bei der noch eine volle Funktionalität und Testbarkeit eines Submoduls 2 gewährleistet ist, aber Mehrfachbestückungen zur Leistungserhöhung eines Submoduls 2 vermieden werden. Eine vorteilhafte Bestückung kann z. B. aus einem oder mehreren IGBTs mit einer Leistungshalbleiterdiode bestehen, wobei Kollektor und Kathode sowie Emitter und Anode miteinander elektrisch verbunden sind.

Jedes Submodul 2 weist genau ein Substrat 6 auf, das aus irgendeinem elektrisch isolierenden und hinreichend wärmeleitenden Material, beispielsweise einer Isolationskeramik, besteht. Dabei soll der thermische Ausdehnungskoeffizient dem des Halbleiterchips 3 angepasst und bevorzugt kleiner als 10 ppm/K sein. Insbesondere sind neben AlN - Keramiken auch solche aus Aluminiumoxid (Al₂O₃), Siliziumkarbid (SiC) oder Diamant geeignet.

Die Metallisierung 5 kann aus Kupfer bestehen und mit einem üblichen Verfahren, z. B. DCB (direct copper bonding), auf die Substratoberseite 6a aufgebracht werden. Eine Metallisierung 5 aus Aluminium hat den Vorteil einer automatischen Passivierung und dadurch grösserer Langzeitstabilität. Statt einer Metallisierung 5 ist beispielsweise auch eine Hartlötung mit einem titanhaltigen Lot möglich.

Anstelle einer Lotschicht 4 zwischen dem Halbleiterchip 3 und dem Substrat 6 kommt auch eine andere stoffschlüssige Verbindung bzw. Befestigung in Frage, die einen guten elektrischen und thermischen Kontakt gewährleistet. Insbesondere ist eine Druckhalterung und -kontaktierung der Submodule 2 denkbar.

Der Kühler 7 soll aus giessfähigen Materialien mit guter Wärmeleitfähigkeit bestehen. Der Kühlkörper 7a muss und die Kühlstrukturen können aus einem Material mit einem dem Substrat 6 angepassten Ausdehnungskoeffizienten bestehen. Eine vorteilhafte Wahl sind Metall - Keramik Kompositmaterialien, insbesondere Siliziumkarbide (SiC), z. B. AlSiC oder CuSiC. Dabei ist ein Kühlkörper 7a aus einem Metall - Keramik Kompositmaterial (AlSiC, CuSiC) gut mit Kühlstrukturen 7b aus dem gleichen Kompositmaterial oder aus dem zugehörigen Metall (Al, Cu) kombinierbar. Der Kühler 7 wird in einem Druckinfiltrations- oder Kapillarverfahren, das aus der Herstellung von Metall - Keramik Kompositen bekannt ist, direkt auf das Keramiksubstrat 6 gegossen. Dabei wird eine Keramik 6 auf eine Vorform aus SiC gelegt und dann diese Vorform mit flüssigem Aluminium oder Kupfer infiltriert. Bei dieser Infiltration bildet sich eine feste Verbindung zwischen dem Metall und der Keramik.

Die gleiche Vergiesstechnik kann auch für den Kühleraufbau gemäss Fig. 2 angewendet werden, insbesondere um eine Al-, Cu- oder andere Metall - Legierung direkt auf das Keramiksubstrat 6 aufzubringen. Auf diese Weise wird eine hochfeste, dauerhafte und sehr gut wärmeleitfähige Verbindung zwischen der Keramik 6 und den Metallnoppen 7b geschaffen. Besonders günstig ist es, wenn in einem einzigen Arbeitsgang Metallnoppen 7b auf die Unterseite 6b des Substrates 6 bzw. den Kühlkörper 7a und eine gleichartige Metallisierung 5 auf die Oberseite 6a des Substrates 6 aufgebracht werden.

Die Kühlstrukturen 7b dienen dazu, die Wärmeübergangsfläche zu vergrössern. Für Materialien mit genügend kleinen Ausdehnungskoeffizienten, z. B. AlSiC oder CuSiC, können die Kühlstrukturen beliebige Gestalt und grosse Kontaktflächen mit dem Substrat 6 oder Kühlkörper 7a haben. Bei grossen Ausdehnungskoeffizienten, z. B. über 10 ppm / K, insbesondere bei Metallen wie Aluminium oder Kupfer, sind kleinflächige Kühlstrukturen wie kleine Noppen oder kurze Rippen vorzuziehen. Im Falle eines Kühlkörpers 7a gemäss Fig. 1 können die Kühlstrukturen jedoch auch ganz weggelassen werden.

Alternativ zu AlSiC kann auch das neu entwickelte Metall AlSi Verwendung finden. AlSi wurde erst kürzlich im Rahmen eines EU - Projektes für Raumfahrtanwendungen zur Produktreife gebracht. AlSi hat einen dem Substrat 6 angepassten thermischen Ausdehnungskoeffizienten, ist sehr einfach in verschiedensten Formen spritzbar, potentiell kostengünstig herstellbar und somit für die hier vorgesehene Verwendung sehr gut geeignet.

Das Gehäuse 8 kann ausser aus Kunststoff auch aus einem anderen Dielektrikum oder aus Metall bestehen. Vorteilhafterweise ist es in einem weiten Temperaturbereich, z. B. zwischen -40 °C und 150 °C, mechanisch und chemisch stabil, unbrennbar, wasserundurchlässig und gut verklebbar. Die Gehäuseform kann in einem weiten Rahmen variiert werden. Insbesondere kann das Gehäuse 8 Mittel zur Führung des Wasser- oder Kühlmedienflusses, wie z. B. Wände, Kühlkanäle usw., aufweisen. Auch können die Kühlstrukturen 7b wie in den Fig. 1 und 2 dargestellt bis zum Gehäuseboden reichen. Die dadurch entstehenden Kühlkanäle zeichnen sich durch einen sehr effizienten Wärmeaustausch bei geringer Wasserdurchflussmenge aus. Die Abdichtungen 11 können mit zusätzlichen Gummiringen zur Pufferung der unterschiedlichen thermischen Ausdehnungen versehen sein.

Als Kühlmedien 9 für die Leistungshalbleitermodule 1 können ausser Wasser 9 auch eine andere Flüssigkeit oder ein Gas vorgesehen sein. Im Falle einer Gasoder Luftkühlung kann der Gehäuseboden 6b weggelassen werden und es besteht eine grosse Freiheit in der Anordnung der Submodule 2. Insbesondere können diese auf einer Platte 6a mit auf beide Seiten abstehenden Kühlern 7 montiert sein.

Erfindungsgemässe Leistungshalbleitermodule 1 können auch mit herkömmlichen Leistungshalbleitermodulen kombiniert werden, die z. B. mehrere Submodule 2 auf einer gemeinsamen Kompositplatte mit einer gemeinsamen Kühlstruktur aufweisen.

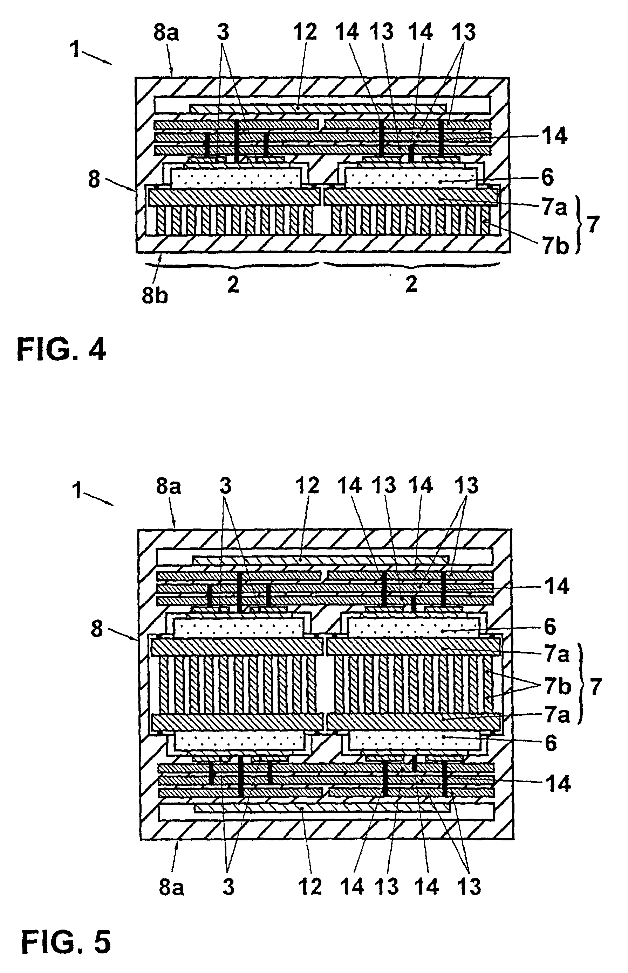

Weitere Ausführungsbeispiele sind in den Fig. 4 - 6 dargestellt. Fig. 4 zeigt ein Leistungshalbleitermodul 1, welches eine Steuerelektronik 12, Leiterbahnen oder Leiterplatten 13 und Kontakte 14 zur elektrischen Verbindung der Leiterplatten 13 mit den Submodulen 2 umfasst. Die Kontakte 14 sind bevorzugt Presskontakte oder Pressstifte. Sie können auch als Bonddrähte ausgebildet sein, die durch Aussparungen geführt sind. Die Steuerelektronik 12, die Leiterplatten 13 und die Submodule 2 sind in einem gemeinsamen Gehäuse 8 integriert. Das Gehäuse 8 besteht vorzugsweise aus Kunststoff. Es ist so geformt, dass die Steuerelektronik 12 oberhalb der Leiterplatten 13 angeordnet werden kann. Die Leiterplatten 13 können in das Gehäuse eingelassen sein, im Gehäuse vergossen sein oder anderweitig dielektrisch isoliert montiert sein. Die Anzahl der Leiterplatten 13 hängt von der Anwendung ab. Beispielsweise werden für einen Phasenzweig drei Leiterplatten 13 benötigt, nämlich je eine für die + und-Zuführung und eine für die Phase.

Fig. 5 zeigt eine weitere bevorzugte Ausführungsform des Leistungshalbleitermoduls 1. Hier sind zwei Leistungshalbleitermodule 1, wie sie bisher beschrieben wurden, zueinander bezüglich der Gehäuseunterseite 8b gespiegelt angeordnet. Die Gehäuseunterseiten 8b sind weggelassen, so dass die zuvor separaten Module 1 einen gemeinsamen, beideitig wirksamen Kühler 7 aufweisen und in einem gemeinsamen Gehäuse 8 untergebracht sind. Ein Vorteil dieses Leistungshalbleitermoduls 1 besteht darin, dass auf äusserst einfache Weise eine Verdoppelung der Leistung erzielbar ist. Weitere Vorteile ergeben sich aus seiner Kompaktheit, einfachen Kühlerstruktur und einfachen Kühlmittelzuführung. Insgesamt resultiert eine erhebliche Steigerung der Leistungsdichte. Eine mögliche Anwendung solcher spiegelsymmetrischer Leistungshalbleitermodule 1 ist beispielsweise die Parallelschaltung mehrerer Phasenzweige für zweistufige Spannungsumrichter. Die Parallelschaltung kann entweder zwischen einzelnen Modulen 1 erfolgen oder auch innerhalb eines Moduls 1. Idealerweise sind in einem Leistungshalbleitermodul 1 vier Phasenzweige zusammengefasst, die zur Bildung eines **zweistufigen?** Phasenzweigs, einer **zweistufigen?** Halbbrücke oder eines Zweipunkt - Umrichters mit integriertem Bremschopper geeignet sind.

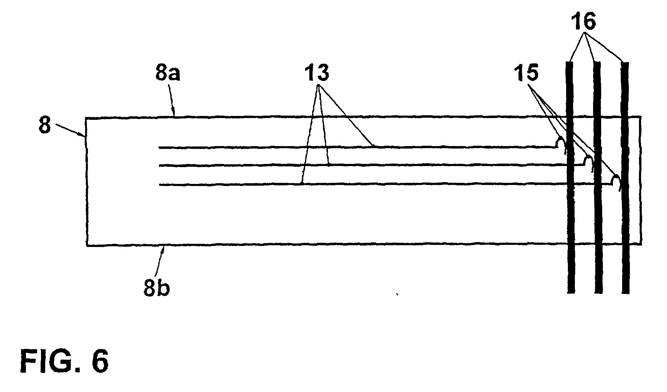

Fig. 6 zeigt schliesslich, dass im Gehäuse 8 zusätzlich Stromschienen 16 zur Kontaktierung der Leiterplatten 13 angeordnet sein können. Vorzugsweise sind die Stromschienen 16 über Schleifkontakte 15 mit den Leiterplatten 13 kontaktiert. Durch die Integration der Stromschienen 16 in das Leistungshalbleitermodul 1 kann der Zusammenbau mehrerer Leistungshalbleitermodule 1 zu grösseren Leistungseinheiten weiter vereinfacht werden.

Neben den eingangs erwähnten Vorteilen haben erfindungsgemässe Leistungshalbleitermodule 1 weitere Vorzüge. Wegen der erhöhten Kühleffizienz und Betriebssicherheit der Submodule 2 mit integrierten Kühlern 7 sind die Leistungshalbleitermodule 1 besonders für Hochleistungsanwendungen in Traktionsantrieben geeignet. Die Kühler 7 sind relativ einfach und kostengünstig aus Metall - Keramik Kompositmaterialien herstellbar. Insbesondere entfällt die Herstellung und Bearbeitung grossflächiger Kühlplatten oder komplizierter Kühlgehäuse aus Kompositen. Schliesslich ist die modulare Struktur 2, 7 der Leistungshalbleitermodule 1 gut mit der Integration weiterer Elemente, insbesondere der Steuerelektronik 12, der Leiterplatten 13 und der Stromschienen 16, kompatibel.

Insgesamt wird durch die Erfindung ein Leistungshalbleitermodul 1 mit Submodulen 2 und quasi monolithisch integrierten, modularen Kühlern 7 realisiert, das sich durch eine deutlich verbesserte thermische Lastwechselfestigkeit und Langzeit - Zuverlässigkeit, eine kompakte Bauweise und hohe Leistungsdichte auszeichnet.

## Patentansprüche

1. Leistungshalbleitermodul (1) mit einer Mehrzahl von Submodulen (2) mit jeweils mindestens einem Halbleiterchip (3), der auf einer Oberseite (6a) eines Substrats (6) stoffschlüssig befestigt ist, wobei das Substrat (6) elektrisch isolierend und gut wärmeleitend ist und einen an den Halbleiterchip (3) angepassten Ausdehnungskoeffizienten aufweist, **dadurch gekennzeichnet, dass**
a) ein Submodul (2) genau ein Substrat (6) mit einem Kühler (7) aus einem gut wärmeleitenden Material aufweist und
b) der Kühler (7) mit der Unterseite (6b) des Substrats (6) vergossen ist.

2. Leistungshalbleitermodul (1) nach Anspruch 1, **dadurch gekennzeichnet, dass** der Kühler (7) einen Kühlkörper (7a) und/oder Kühlstrukturen (7b) aufweist.

3. Leistungshalbleitermodul (1) nach Anspruch 2, **dadurch gekennzeichnet, dass** die Kühlstrukturen (7b) direkt mit dem Substrat (6) vergossen sind und Noppen oder Rippen aufweisen.

4. Leistungshalbleitermodul (1) nach einem der Ansprüche 2 - 3, **dadurch gekennzeichnet, dass**
a) der Kühlkörper (7a) aus einem Material mit einem dem Substrat (6) angepassten Ausdehnungskoeffizienten besteht und/oder
b) die Kühlstrukturen (7b) aus einem Material mit einem dem Substrat (6) angepassten Ausdehnungskoeffizienten oder aus einem Metall bestehen.

5. Leistungshalbleitermodul (1) nach Anspruch 4, **dadurch gekennzeichnet, dass**
a) das Substrat (6) aus einer Isolationskeramik besteht,
b) der Kühlkörper (7a) aus einem Metall - Keramik Kompositmaterial, insbesondere einem Siliziumkarbid, besteht und
c) die Kühlstrukturen (7b) aus dem gleichen Kompositmaterial oder dem zugehörigen Metall bestehen.

6. Leistungshalbleitermodul (1) nach einem der Ansprüche 2 - 5, **dadurch gekennzeichnet, dass**
a) die Submodule (2) nebeneinander in Aussparungen (9) auf einer gemeinsamen Platte oder Gehäuseoberseite (8a) angeordnet sind und
b) die Kühler (7) zur gleichen Seite, insbesondere zu einer Gehäuseunterseite (8b), hin orientiert sind.

7. Leistungshalbleitermodul (1) nach Anspruch 6, **dadurch gekennzeichnet, dass**
a) das Leistungshalbleitermodul (1) ein Gehäuse (8) zur Umschliessung der Kühler (7) und eines Kühlmediums (10) umfasst und
b) als Kühlmedium (10) eine Flüssigkeit, insbesondere Wasser, oder ein Gas vorgesehen ist.

8. Leistungshalbleitermodul (1) nach Anspruch 7, **dadurch gekennzeichnet, dass**
a) die Gehäuseoberseite (8a) im Randbereich der Submodule (2) Abdichtungen (11) in Form von O - Ringen, einer dicken Leimverbindung o. ä. aufweist und
b) das Gehäuse (8) Mittel zur Führung des Kühlmedienflusses aufweist.

9. Leistungshalbleitermodul (1) nach einem der Ansprüche 4 - 8, **dadurch gekennzeichnet, dass**
a) das Submodul (2) eine minimale Bestückung mit Halbleiterchips (3), insbesondere einen IGBT mit einer Leistungsdiode, aufweist,
b) das Substrat (6) aus einer AlN -, Al₂O₃ -, SiC - oder Diamant - Keramik besteht,
c) der Kühlkörper (7a) aus AlSiC, CuSiC oder AlSi und/oder die Kühlstrukturen (7b) aus AlSiC, CuSiC, AlSi, Aluminium oder Kupfer bestehen und
d) das Gehäuse (6) aus einem Dielektrikum, insbesondere Kunststoff, oder aus Metall besteht.

10. Leistungshalbleitermodul (1) nach einem der Ansprüche 1 - 9, **dadurch gekennzeichnet, dass**
a) das Leistungshalbleitermodul (1) eine Steuerelektronik (12), Leiterplatten (13) und Kontakte (14) zur elektrischen Verbindung der Leiterplatten (13) mit den Submodulen (2) umfasst,
b) die Steuerelektronik (12), die Leiterplatten (13) und die Submodule (2) in einem gemeinsamen Gehäuse (8) integriert sind und
c) insbesondere im Gehäuse (8) zusätzlich Stromschienen (16) zur Kontaktierung der Leiterplatten (13) angeordnet sind.

11. Leistungshalbleitermodul (1) nach einem der Ansprüche 1 - 10, **dadurch gekennzeichnet, dass** zwei Leistungshalbleitermodule (1) nach einem der Ansprüche 1 - 10 zueinander gespiegelt angeordnet sind, einen gemeinsamen Kühler (7) aufweisen und in einem gemeinsamen Gehäuse (8) untergebracht sind.

12. Leistungshalbleitermodul (1) nach einem der Ansprüche 1 - 11, **dadurch gekennzeichnet, dass** eine Anzahl von Submodulen (2) nach Massgabe einer geforderten Schaltleistung des Leistungshalbleitermoduls (1) gewählt ist.

## Claims

1. Power semiconductor module (1) having a plurality of submodules (2) which each have at least one semiconductor chip (3) integrally mounted on a top (6a) of a substrate (6), the substrate (6) being electrically insulating, having good thermal conductivity and having an expansion coefficient which is matched to the semiconductor chip (3), **characterized in that**
a) a submodule (2) has just one substrate (6) with a heat sink (7) made of a material having good thermal conductivity, and
b) the heat sink (7) is sealed together with the underside (6b) of the substrate (6).

2. Power semiconductor module (1) according to Claim 1, **characterized in that** the heat sink (7) has a cold body (7a) and/or cooling structures (7b).

3. Power semiconductor module (1) according to Claim 2, **characterized in that** the cooling structures (7b) are sealed directly together with the substrate (6) and have nubs or ribs.

4. Power semiconductor module (1) according to one of Claims 2 - 3, **characterized in that**
a) the cold body (7a) is composed of a material having an expansion coefficient which is matched to the substrate (6), and/or
b) the cooling structures (7b) are composed of a material having an expansion coefficient which is matched to the substrate (6), or are composed of a metal.

5. Power semiconductor module (1) according to Claim 4, **characterized in that**
a) the substrate (6) is composed of an insulating ceramic,
b) the cold body (7a) is composed of a metal/ceramic composite material, in particular a silicon carbide, and
c) the cooling structures (7b) are composed of the same composite material or the associated metal.

6. Power semiconductor module (1) according to one of Claims 2 - 5, **characterized in that**
a) the submodules (2) are arranged next to one another in recesses (9) on a common plate or housing top (8a), and
b) the heat sinks (7) are oriented towards the same side, in particular towards a housing underside (8b).

7. Power semiconductor module (1) according to Claim 6, **characterized in that**
a) the power semiconductor module (1) comprises a housing (8) for enclosing the heat sinks (7) and a cooling medium (10), and
b) the cooling medium (10) provided is a liquid, in particular water, or a gas.

8. Power semiconductor module (1) according to Claim 7, **characterized in that**
a) the housing top (8a) has seals (11) in the form of O-rings, a thick glue joint or the like in the edge region of the submodules (2), and
b) the housing (8) has means for directing the flow of cooling medium.

9. Power semiconductor module (1) according to one of Claims 4 - 8, **characterized in that**
a) the submodule (2) has a minimal population of semiconductor chips (3), in particular an IGBT with a power diode,
b) the substrate (6) is composed of an AlN, Al₂O₃, SiC or diamond ceramic,
c) the cold body (7a) is composed of AlSiC, CuSiC or AlSi and/or the cooling structures (7b) are composed of AlSiC, CuSiC, AlSi, aluminium or copper, and
d) the housing (6) [sic] is composed of a dielectric, in particular plastic, or is composed of metal.

10. Power semiconductor module (1) according to one of Claims 1 - 9, **characterized in that**
a) the power semiconductor module (1) comprises control electronics (12), printed circuit boards (13) and contacts (14) for electrically connecting the printed circuit boards (13) to the submodules (2),
b) the control electronics (12), the printed circuit boards (13) and the submodules (2) are integrated in a common housing (8), and
c) busbars (16) are additionally arranged in particular in the housing (8), for making contact with the printed circuit boards (13).

11. Power semiconductor module (1) according to one of Claims 1 - 10, **characterized in that** two power semiconductor modules (1) according to one of Claims 1 - 10 are arranged as mirror images of one another, have a common heat sink (7) and are accommodated in a common housing (8).

12. Power semiconductor module (1) according to one of Claims 1 - 11, **characterized in that** a number of submodules (2) are chosen on the basis of the switching capacity required from the power semiconductor module (1).

## Revendications

1. Module à semiconducteur de puissance (1) comprenant une pluralité de sous-modules (2) ayant chacun au moins une puce en semiconducteur (3) qui est fixée par adhérence des matériaux sur le côté supérieur (6a) d'un substrat (6), le substrat (6) étant isolé électriquement et bon conducteur thermique et présentant un coefficient de dilatation adapté à celui de la puce en semiconducteur (3), **caractérisé en ce que**
a) un sous-module (2) présente exactement un substrat (6) avec un radiateur (7) en un matériau bon conducteur thermique et
b) le radiateur (7) est moulé avec le côté inférieur (6b) du substrat.

2. Module à semiconducteur de puissance (1) selon la revendication 1, **caractérisé en ce que** le radiateur (7) présente un corps de radiateur (7a) et/ou des structures de refroidissement (7b).

3. Module à semiconducteur de puissance (1) selon la revendication 2, **caractérisé en ce que** les structures de refroidissement (7b) sont directement moulées avec le substrat (6) et elles présentent des nervures ou des ailettes.

4. Module à semiconducteur de puissance (1) selon l'une des revendications 2 - 3, **caractérisé en ce que**
a) le corps de radiateur (7a) est réalisé dans un matériau dont le coefficient de dilatation est adapté à celui du substrat (6) et/ou
b) les structures de refroidissement (7b) sont réalisées dans un matériau dont le coefficient de dilatation est adapté à celui du substrat (6) ou en métal.

5. Module à semiconducteur de puissance (1) selon la revendication 4, **caractérisé en ce que**
a) le substrat (6) est réalisé dans une céramique isolante,
b) le corps de radiateur (7a) est réalisé dans un matériau composite métal-céramique, plus particulièrement un carbure de silicium, et
c) les structures de refroidissement (7b) sont réalisées dans le même matériau composite ou dans le métal correspondant.

6. Module à semiconducteur de puissance (1) selon l'une des revendications 2 - 5, **caractérisé en ce que**
a) les sous-modules (2) sont disposés l'un à côté de l'autre dans des évidements (9) sur une plaque commune ou sur le côté supérieur du boîtier (8a) et
b) les radiateurs (7) sont dirigés du même côté, notamment vers un côté inférieur du boîtier (8b).

7. Module à semiconducteur de puissance (1) selon la revendication 6, **caractérisé en ce que**
a) le module à semiconducteur de puissance (1) comprend un boîtier (8) pour renfermer le radiateur (7) et un fluide de refroidissement (10) et
b) le fluide de refroidissement (10) prévu est un liquide, notamment de l'eau, ou un gaz.

8. Module à semiconducteur de puissance (1) selon la revendication 7, **caractérisé en ce que**
a) le côté supérieur du boîtier (8a) présente des dispositifs d'étanchéité (11) sous la forme de joints toriques, d'une liaison collée épaisse ou similaire dans la zone de bordure des sous-modules (2) et
b) le boîtier (8) présente des moyens pour guider l'écoulement du fluide de refroidissement.

9. Module à semiconducteur de puissance (1) selon l'une des revendications 4 - 8, **caractérisé en ce que**
a) le sous-module (2) présente un équipement minimum composé de puces en semiconducteur (3), notamment un IGBT avec une diode de puissance,
b) le substrat (6) est réalisé en une céramique à l'AlN, Al₂O₃, SiC ou au diamant,
c) le corps de radiateur (7a) est réalisé en AlSiC, CuSiC ou AlSi et/ou les structures de refroidissement (7b) sont réalisées en AlSiC, CuSiC, AlSi, aluminium ou cuivre et
d) le boîtier (6) est réalisé en matériau diélectrique, notamment du plastique, ou en métal.

10. Module à semiconducteur de puissance (1) selon l'une des revendications 1 - 9, **caractérisé en ce que**
a) le module à semiconducteur de puissance (1) comprend une électronique de commande (12), des plaques conductrices (13) et des contacts (14) pour relier électriquement les plaques conductrices (13) avec les sous-modules (2),
b) l'électronique de commande (12), les plaques conductrices (13) et les sous-modules (2) sont intégrés dans un boîtier commun (8) et
c) des barres bus (16) supplémentaires sont notamment disposées dans le boîtier (8) pour établir le contact avec les plaques conductrices (13).

11. Module à semiconducteur de puissance (1) selon l'une des revendications 1 - 10, **caractérisé en ce que** deux modules à semiconducteur de puissance (1) selon l'une des revendications 1 - 10 sont disposés symétriquement l'un par rapport à l'autre, présentent un radiateur commun (7) et sont logés dans un boîtier commun (8).

12. Module à semiconducteur de puissance (1) selon l'une des revendications 1 - 11, **caractérisé en ce que** le nombre de sous-modules (2) est choisi en fonction de la puissance de commutation requise du module à semiconducteur de puissance (1).
